(19) Europäisches Patentamt
European Patent Office
Office européen des brevets

(11) Veröffentlichungsnummer: **0 094 914**
**B1**

(12) **EUROPÄISCHE PATENTSCHRIFT**

(45) Veröffentlichungstag der Patentschrift: **24.09.86**

(51) Int. Cl.⁴: **G 03 C 1/68**, C 08 G 59/68, C 08 G 65/10

(21) Anmeldenummer: **83810206.9**

(22) Anmeldetag: **13.05.83**

(54) **Photopolymerisation mittels organometallischer Salze.**

(30) Priorität: **19.05.82 GB 8214609**

(43) Veröffentlichungstag der Anmeldung: **23.11.83 Patentblatt 83/47**

(45) Bekanntmachung des Hinweises auf die Patenterteilung: **24.09.86 Patentblatt 86/39**

(84) Benannte Vertragsstaaten: **CH DE FR GB IT LI NL SE**

(56) Entgegenhaltungen:
**US-A-3 709 861**

**DIE ANGEWANDTE MAKROMOLEKULARE CHEMIE, Band 50, Nr. 735, Februar 1976, Seiten 9-14, Basel, CH., D.L.S. BROWN et al.: "Organo-metal carbonyl compounds of iron, molybdenum, and manganese as photosensitisers of the anhydride cure of epoxy resins"**

(73) Patentinhaber: **CIBA- GEIGY AG, Klybeckstrasse 141, CH- 4002 Basel (CH)**

(72) Erfinder: **Irving, Edward, Dr., 41, Swaffham Road, Burwell Cambridge CB5 0AN (GB)**
Erfinder: **Johnson, Brian Frederick Gilbert, Dr., 11 Ascham Lane, Whittlesford Cambridge CB2 4NT (GB)**
Erfinder: **Meier, Kurt, Dr., Ulmenstrasse 11, CH- 4123 Allschwil (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 094 914 B1

LIBER, STOCKHOLM 1986

**Beschreibung**

Vorliegende Erfindung betrifft Zusammensetzungen, die 1,2-Epoxide und gewisse Typen organometallischer Salze sowie gegebenenfalls gewisse Typen von Photobeschleunigern enthalten. Ferner betrifft sie die Polymerisation solcher Zusammensetzungen mittels aktinischer Strahlung, die weitere Vernetzung so erhaltener polymerisierter Produkte durch Hitze in Gegenwart von Heisshärtern sowie die Verwendung der Zusammensetzungen als Oberflächenbeschichtungen, in Druckplatten, in gedruckten Schaltungen und in verstärkten Verbundstoffen sowie als Klebstoffe.

Aus verschiedenen Gründen hat es sich als wünschenswert erwiesen, die Polymerisation mittels aktinischer Strahlung einzuleiten. Durch den Einsatz von Photopolymerisationsmethoden kann man beispielsweise die Verwendung organischer Lösungsmittel mit den begleitenden Risiken der Toxizität, Brennbarkeit und Umweltverschmutzung und die Kosten zur Rückgewinnung des Lösungsmittels vermeiden. Photopolymerisation ermöglicht es, das Unlöslichwerden einer Zusammensetzung auf bestimmte Stellen, d.h. die bestrahlten, zu beschränken, und gestattet so die Herstellung von gedruckten Schaltungen und Druckplatten bzw. erlaubt eine Begrenzung der Bindung an Substrate auf die erforderlichen Bereiche. Ferner sind in Herstellungsverfahren Bestrahlungsmethoden häufig schneller als solche, die Erhitzen und eine nachfolgende Kühlstufe umfassen.

In der US-A-3 709 861 sind härtbare Zusammensetzungen beschrieben, die (a) ein Epoxidharz, (b) ein Polycarbonsäureanhydrid oder Polymercaptan als Härter und (c) ein Cyclopentadienylmangan-tricarbonyl als lichtaktivierbaren Beschleuniger, enthalten. Wenn Härtung erfolgen soll, werden die Zusammensetzungen 10 Minuten bis 8 Stunden lang mit aktinischer Strahlung belichtet (in den Beispielen werden Bestrahlungszeiten von 15 Minuten bis 3 Stunden angewandt). Belichtung bei Raumtemperatur ergibt eine berührungsfeste Härtung, doch kann die Zusammensetzung gleichzeitig mit oder nach der Belichtung 1 Stunde bis 3 Tage lang auf 50 bis 250°C erhitzt werden, um die Härtung zu beschleunigen und zu vervollständigen.

Es wurde nun gefunden, dass sich 1,2-Epoxide mittels gewisser Salze von Uebergangsmetallkomplexen mit Arenen und cyclischen Dienen photopolymerisieren lassen. Diese Salze sind im allgemeinen in flüssigen 1,2-Epoxiden löslich und somit unter Bildung einer photopolymerisierbaren Zusammensetzung leicht einarbeitbar, ohne dass man toxische oder brennbare Lösungsmittel oder komplizierte Dispergierapparate anwenden müsste.

Die in den erfindungsgemässen Zusammensetzungen verwendeten Salze besitzen beim Erhitzen in Abwesenheit aktinischer Strahlung wenig oder keine Wirkung auf 1,2-Epoxide. So erfolgte bei 40 Stunden langem Erhitzen auf 150°C keine Gelierung einer 2 Gewichtsteile Tricarbonyl-(cyclohexa-2,4-dienylium)-eisen-tetrafluoroborat und 100 Gewichtsteile eines handelsüblichen Epoxidharzes, des Diglycidyläthers des 2,2-Bis-(4-hydroxyphenyl)-propans, enthaltenden Zusammensetzung. Daraus folgt, dass die erfindungsgemässen Zusammensetzungen wünschenswert lange Topfzeiten besitzen, wenn sie vor aktinischer Strahlung geschützt sind.

Gegenstand dieser Erfindung sind dementsprechend polymerisierbare Zusammensetzungen enthaltend

(a) eine mindestens eine 1,2-Epoxidgruppe enthaltende Verbindung bzw. ein, Gemisch solcher Verbindungen und

(b) eine wirksame, Menge eines Salzes der Formel

$[Y\text{-}Q\text{-}(CO)_a]^+ \; MX_n^-$ I

worin Y eine Arengruppe oder cyclische Dienyliumgruppe bedeutet, Q ein Atom eines unter Titan, Vanadium, Chrom, Mangan, Eisen, Kobalt, Nickel, Kupfer; Niob, Molybdän, Ruthenium, Rhodium, Palladium, Silber; Tantal, Wolfram, Rhenium, Osmium, Iridium, Platin und Gold ausgewählten d-Block-Ubergangsmetalls darstellt, a eine solche positive ganze Zahl ist, dass das Atom Q eine geschlossene Elektronenschalenkonfiguration aufweist, M ein Atom eines Metalls oder Nichtmetalls darstellt, n 4, 5 oder 6 und um eins grösser als die Wertigkeit von M ist und X für ein Fluor- oder Chloratom steht, mit der Massgabe, dass, wenn M Antimon darstellt, n 6 ist und fünf der Symbole X für Fluor stehen, eines auch eine Hydroxogruppe bedeuten kann.

Gegenstand dieser Erfindung ist weiterhin ein Verfahren zur Ueberführung einer mindestens eine 1,2-Epoxidgruppe enthaltenden Verbindung bzw. eines Gemischs solcher Verbindungen in höhermolekularcs Material, dadurch gekennzeichnet, dass man diese erfindungsgemässe Zusammensetzung aktinischer Strahlung aussetzt.

Wenn Y eine Arengruppe bedeutet, d.h. selbst ein 6-Elektronenligand ist, so kann es eine einkernige oder mehrkernige Gruppe, einschliesslich einer kondensierten Ringgruppe, sein. Vorzugsweise ist es eine gegebenenfalls durch eine oder mehrere Alkoxygruppen substituierte Kohlenwasserstoffgruppe und enthält vorzugsweise 6 bis 18 Kohlenstoffatome, wie Benzol, Toluol, Mesitylen, Naphthalin, Biphenyl, Phenanthren, Fluoren und Anthracen.

Wenn Y eine cyclische Dienyliumgruppe bedeutet, so ist es vorzugsweise eine Gruppe einer der folgenden Formeln

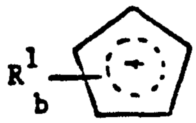 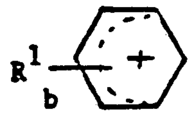 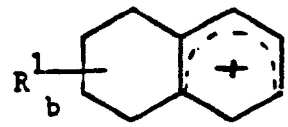

II II V

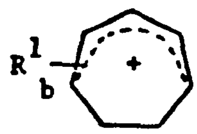 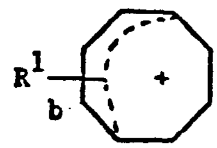

V VI,

worin $R^1$ für eine Alkylgruppe mit 1 bis 4 Kohlenstoffatomen, eine Alkoxygruppe mit 1 bis 4 Kohlenstoffatomen oder eine durch eine oder mehrere Oxycarbonylgruppen unterbrochene Alkylgruppe mit bis zu 12 Kohlenstoffatomen steht und b null, 1, 2 oder 3 ist.

Q steht vorzugsweise für Chrom, Kobalt, Nickel und insbesondere Eisen oder Mangan.

Das Atom M kann beispielsweise Eisen, Zinn, Wismut, Aluminium, Gallium, Indium, Titan, Zirkon, Scandium, Vanadium, Chrom oder Mangan, jedoch vorzugsweise Antimon, Arsen, Bor oder Phosphor darstellen. Das Kation $MX_n^-$ kann somit beispielsweise Tetrachloroaluminat oder Hexachloroferrat bedeuten, doch steht es vorzugsweise für Tetrafluoroborat, Hexafluoroarsenat, Hydroxopentafluoroantimonat, Hexafluoroantimonat oder Hexafluorophosphat.

Salze der Formel I, in denen Y eine Arengruppe bedeutet, lassen sich durch Erhitzen von beispielsweise Pentacarbonylmanganbromid mit einem Aren in Gegenwart von Aluminiumchlorid und Behandlung des Produkts in wässriger Lösung mit beispielsweise Kaliumhexafluorophosphat zur Ausfällung des Arentricarbonylmangan-hexafluorophosphats herstellen (T.H. Coffield, V. Sandel und R.D. Closson, J. Amer. Chem. Soc., 1957, 79, 5826).

Besonders bevorzugte einzelne Salze der Formel I, worin Y eine Arengruppe bedeutet, sind unter anderem die Hexafluorophosphate des π-Toluoltricarbonylmangans, π-Bensoltricarbonylmangans, π-Mesitylentricarbonylmangans, π-1-Methyl-5,6,7,8-tetrahydronaphthalintricarbonylmangans, π-Hexylbenzoltricarbonylmangans, π-Methoxybenzoltricarbonylmangans und π-Hexyloxybenzoltricarbonylmangans.

Diese Salze erfüllen die Forderung, dass das Zentralatom (Mangan) eine geschlossene Elektronenschalenkonfiguration besitzt, d.h. 18 Elektronen in seiner Valenzschale, wobei einwertiges Mangan mit seinem einfach positiven Kation 6 Elektronen, die Arengruppe 6 Elektronen und die drei Carbonylgruppen je 2 Elektronen beisteuern.

Salze der Formel I, worin Y eine cyclische Dienyliumgruppe bedeutet, sind ebenfalls allgemein bekannt.

Beispielsweise erhitzt man ein Dien mit einem Metallcarbonyl, wie Eisenpentacarbonyl, zur Bildung eines neutralen Komplexes, z.B. Tricarbonyl-(cyclohexa-1,3-dien)-eisen, und Abspaltung eines Hydridions aus dem Komplex mittels Triphenylmethyltetrafluoroborat ergibt das entsprechende Tricarbonyl-(cyclohexadienylium)-eisen-tetrafluoroborat (E.O. Fischer und R.D. Fischer, Angew. Chem. 1960, 72, 919; A.J. Birch, K.B. Chamberlain, M.A. Haas and D.J. Thompson, J. Chem. Soc., Perkin 1, 1973, 1882). Das Hexafluorophosphat oder ein anderes gewünschtes Salz der Formel I lässt sich auf ähnliche Weise unter Verwendung von Triphenylmethylhexafluorophosphat bzw. entsprechender Salze herstellen.

Die Reaktion von Cyclopentadienyleisen-dicarbonylbromid mit Kohlenmonoxyd in einem inerten Lösungsmittel in Gegenwart von Aluminiumtribromid als Katalysator mit nachfolgender Hydrolyse und dann Behandlung mit Ammoniumhexafluorophosphat liefert Tricarbonyl-(cyclopentadienyl)-eisenhexafluorophosphat (E.O. Fischer und K. Fichtel, Chem. Ber., 1961, 94, 1200).

Die Umsetzung eines Cyclopentadienyleisen-dicarbonylhalogenids mit Kohlenmonoxyd in Acetonlösung mit Natriumtetraphenylborat ergibt Tricarbonyl-(cyclopentadienyl)-eisentetraphenylborat (A. Davison, M.L.H. Green und G. Wilkinson, J. Chem. Soc., 1961, 3172), aus dem sich Salze, wie das Tetrafluoroborat, herstellen lassen.

Auch kann man ein solches Cyclodienyleisen-dicarbonylhalogenid in Gegenwart eines Gemischs aus Hexafluorophosphorsäure und Propionsäureanhydrid carbonylieren, was Tricarbonyl-(cyclopentadienyl)-eisen-, Tricarbonyl-(cycloheptatrienyl)-eisen- und Tricarbonyl-(cyclooctatetraenyl)-eisenhexafluorophosphat ergibt (R.B. King, Inorg. Chem., 1962, 1, 964).

Tetracarbonyl-(cyclopentadienylium)-molybdän-hexafluorophosphat bzw. Tetracarbonyl-(cyclopentadienylium)-wolfram-hexafluorophosphat lassen sich durch Umsetzung des

Cyclopentadienylmolybdän-tricarbonylchlorids bzw. der entsprechenden Wolframverbindung mit Kohlenmonoxyd in Gegenwart von Aluminiumchlorid und nachfolgende Behandlung des Tetracarbonyl-(cyclopentadienylium)-tetrachloroaluminats mit Ammoniumhexafluorophosphat herstellen (E.0. Fischer, K. Fichtel und K. Öfele, Chem. Ber., 1962, 95, 249-252).

Tetracarbonyl-(cyclopentadienyl)-chrom-tetrafluoroborat ist durch Umsetzung des Hydridotricarbonyl-(cyclopentadienyl)-chroms mit Bortrifluorid-dimethylätherat in Benzol in einer Kohlenmonoxydatmosphäre erhältlich (E.O. Fischer und K. Ulm, Z. Naturforsch., 1961, 16 B, 757).

Besonders bevorzugte einzelne Salze der Formel I, worin Y eine cyclische Dienyliumgruppe bedeutet, sind unter anderem Tricarbonyl-(cyclohexa-1,3-dienylium)-eisen-tetra-fluoroborat, Tricarbonyl-(1-methylcyclohexa-2,4-dienylium)-eisen-hexafluorophosphat, Tricarbonyl-(1-methyl-4-methoxy-cyclohexa-2,4-dienylium)-eisen-hexafluorophosphat, Tricar-bonyl-(2-methoxybicyclo[4.4.0]deca-2,4-dienylium)-eisen-hexa-fluorophosphat, Tricarbonyl-(1-(acetoxymethyl)-2-(methoxy-carbonylacetoxy)-äthylcyclohexa-2,4-dienylium)-eisen-hexa-fluorophosphat, Tricarbonyl-(1-äthyl-4-isopropoxycyclohexa-2,4-dienylium)-eisen-hexafluorophosphat und Tricarbonyl-(1-(methoxycarbonyl)-4-methoxycyclohexa-2,4-dienylium)-eisen-tetrafluoroborat.

Diese Salze erfüllen ebenfalls die Forderung, dass das Zentralatom (Eisen) eine geschlossene Elektronenschalenkonfiguration besitzt, wobei das Eisen 7 Elektronen, die Dienyliumgruppe 5 und die Carbonylgruppen ebenfalls je 2 Elektronen (d.h. insgesamt 18) beisteuern.

Die erfindungsgemässen Zusammensetzungen enthalten vorzugsweise 0,5 bis 7,5 und insbesondere 1 bis 5,0 Gewichtsteile (b) auf 100 Gewichtsteile (a).

Zu geeigneten Mono-1,2-epoxiden gehören Epichlorhydrin, Propylenoxyd, Glycidyläther einwertiger Alkohole oder Phenole, wie n-Butylglycidyläther oder Phenylglycidyläther, und Glycidylester von Monocarbonsäuren wie Glycidylacrylat oder Glycidylmethacrylat. Vorzugsweise ist (a) ein Epoxidharz, d.h. eine durchschnittlich mehr als eine 1,2-Epoxidgruppe pro Molekül enthaltende Verbindung, wie ein mehr als eine endständige, direkt an ein Sauerstoffatom gebundene Gruppe der Formel

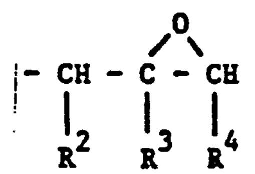

VII,

worin entweder $R^2$ und $R^4$ je für ein Wasserstoffatom stehen, wobei $R^3$ dann ein Wasserstoffatom oder eine Methylgruppe bedeutet, oder $R^2$ und $R^4$ zusammen $-CH_2CH_2-$ darstellen, wobei $R^3$ dann ein Wasserstoffatom bedeutet, enthaltendes Harz.

Als Beispiele für solche Harze seien Polyglycidylund Poly-(β-methylglycidyl)-ester genannt, die durch Umsetzung einer zwei oder mehr Carbonsäuregruppen pro Molekül enthaltenden Verbindung mit Epichlorhydrin, Glycerindichlorhydrin oder β-Methylepichlorhydrin in Gegenwart von Alkali erhältlich sind. Solche Polyglycidylester können sich von aliphatischen Polycarbonsäuren, z.B. Bernsteinsäure, Glutarsäure, Adipinsäure, Pimelinsäure, Korksäure, Azelainsäure, Sebacinsäure oder dimerisierter oder trimerisierter Linolsäure, von cycloaliphatischen Polycarbonsäuren, wie Tetrahydrophthalsäure, 4-Methyltetrahydrophthalsäure, Hexahydrophthalsäure und 4-Methylhexahydrophthalsäure, sowie von aromatischen Polycarbonsäuren, wie Phthalsäure, Isophthalsäure und Terephthalsäure, ableiten. Weitere geeignete Polyglycidylester kann man durch Polymerisation der Glycidylester von Vinylsäuren, insbesondere Glycidylacrylat und Glycidylmethacrylat, erhalten.

Weitere Beispiele sind Polyglycidyl- und Poly-(β-methylglycidyl)-äther, die durch Umsetzung einer mindestens zwei freie alkoholische und/oder phenolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung, erhältlich sind. Diese Aether lassen sich aus acyclischen Alkoholen, wie Aethylenglykol, Diäthylenglykol und höheren Poly(oxyäthylen)-glykolen, Propan-1,2-diol und Poly-(oxypropylen)-glykolen, Propan-1,3-diol, Poly-(oxytetramethylen)glykolen, Pentan-1,5-diol, Hexan-2,4,6-triol, Glycerin, 1,1,1-Trimethylolpropan, Pentaerythrit, Sorbit und Poly(epichlorhydrin), aus cycloaliphatischen Alkoholen, wie Resorcit, Chinit, Bis-(4-hydroxycyclohexyl)-methan, 2,2-Bis-(4-hydroxycyclohexyl)-propan und 1,1-Bis-(hydroxymethyl)-cyclo-hex-3-en, und aus Alkoholen mit aromatischen Kernen, wie N,N-Bis-(2-hydroxyäthyl)-anilin und p,p'-Bis-(2-hydroxyäthyl-amino)-diphenylmethan, herstellen. Man kann sie ferner aus einkernigen Phenolen, wie Resorcin und Hydrochinon, und mehrkernigen Phenolen, wie Bis-(4-hydroxyphenyl)-methan (sonst als Bisphenol F bekannt), 4,4'-Dihydroxydiphenyl, Bis-(4-hydroxyphenyl)-sulfon,-1,1,2,2-Tetrakis-(4-hydroxyphenyl)-äthan, 2,2-Bis-(4-hydroxyphenyl)-propan (sonst als Bisphenol A bekannt), 2,2-Bis-(3,5-dibrom-4-hydroxyphenyl)-propan sowie aus Aldehyden, wie Formaldehyd, Acetaldehyd, Chloral und Furfurol mit Phenol selbst bzw. durch Chloratome oder Alkylgruppen mit jeweils bis zu 9 Kohlenstoffatomen ringsubstituiertem Phenol, wie 4-Chlorphenol, 2-Methylphenol und 4-tert.-Butylphenol, gebildeten Novolaken herstellen.

Poly-(N-glycidyl)-verbindungen kommen ebenfalls in Betracht, z.B. die N-Glycidylderivate von Aminen, wie

Anilin, n-Butylamin, Bis-(4-aminophenyl)-methan und Bis-(4-methyl-aminophenyl)-methan, Triglycidylisocyanurat und N,N'-Diglycidylderivate von cyclischen Alkylenharnstoffen, wie Aethylenharnstoff und 1,3-Propylenharnstoff, und Hydentoinen, wie 5,5,-Dimethylhydantoin. Im allgemeinen sind diese jedoch nicht bevorzugt.

Ferner kommen Poly-(S-glycidyl)-verbindungen in Frage, z.B. Di-(S-glycidyl)-derivate von Dithiolen, wie Aethan-1,2-dithiol und Bis-(4-mercaptomethylphenyl)-äther, doch sind auch diese nicht bevorzugt.

Beispiele für Epoxidharze mit Gruppen der Formel VII, worin $R_2$ und $R_4$ zusammen eine $-CH_2CH_2-$Gruppe darstellen, sind Bis-(2,3-epoxicyclopentyl)-äther, 2,3-Epoxicyclopentyl-glycidyläther und 1,2-Bis-(2,3-epoxicyclopentyloxy)-äthan.

Auch kann man Epoxidharze mit an verschiedene Arten von Heteroatomen gebundenen 1,2-Epoxidgruppen einsetzen, z.B. den Glycidyläther/Glycidylester der Salicylsäure.

Ebenfalls in Betracht kommen Epoxidharze, in denen einige oder sämtliche Epoxidgruppen mittelständig sind, wie Vinylcyclohexendioxyd, Limonendioxyd, Dicyclopentadiendioxyd, 4-Oxatetracyclo[6.2.1.$0^{2,7}$.$0^{3,5}$]undec-9-ylglycidyläther, 1,2-Bis-(4-oxatetracyclo[6.2.1.$0^{2,7}$.$0^{3,5}$]undec-9-yloxy)-äthan, der 3,4-Epoxicyclohexylmethylester der 3',4'-Epoxi-cyclohexancarbonsäure sowie dessen 6,6'-Dimethylderivat, der Bis-(3,4-epoxicyclohexancarbonsäureester) des Aethylenglykols, 3-(3,4-Epoxicyclohexyl)-8,9-epoxi-2,4-dioxaspiro[5.5]undecan sowie epoxidierte Butadiene oder Copolymere von Butadien mit Aethylenverbindungen wie Styrol und Vinylacetat.

Gewünschtenfalls kann man Epoxidharzgemische einsetzen.

Erfindungsgemäss besonders bevorzugt verwendete Epoxidharze sind gegebenenfalls vorverlängerte Diglycidyläther zweiwertiger Phenole, wie 2,2-Bis-(4-hydroxyphenyl)-propan und Bis-(4-hydroxyphenyl)-methan, sowie zweiwertiger aliphatischer Alkohole, wie Butan-1,4-diol.

Bedeutet Y eine Arengruppe, so wird es normalerweise notwendig sein, sowohl Hitze als auch aktinische Strahlung zur Härtung einwirken zu lassen, falls die Epoxidgruppen in (a) der Formel VII entsprechen; bei solchen Salzen wird die Verwendung von Epoxidharzen mit direkt an cycloaliphatische Kohlenstoffatome gebundenen 1,2-Epoxidgruppen bevorzugt.

Vorzugsweise enthalten die erfindungsgemässen Zusammensetzungen ferner einen Photobeschleuniger. Es wurde gefunden, dass durch Einarbeitung geeigneter Photobeschleuniger die Härtungsgeschwindigkeit weiter erhöht wird, was kürzere Belichtungszeiten und/oder die Anwendung weniger starker-Bestrahlungsquellen ermöglicht.

Zu als Photobeschleuniger geeigneten Substanzen gehören die Ketale aromatischer Diketone, insbesondere Verbindungen der Formel

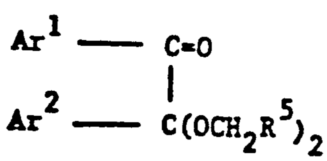

VIII

oder

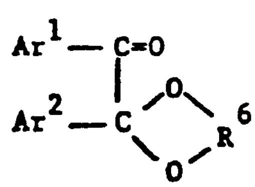

IX,

worin $R^5$ für ein Wasserstoffatom, eine Alkylgruppe mit 1 bis 5 Kohlenstoffatomen, eine Alkenylgruppe mit 2 oder 3 Kohlenstoffatomen, eine Aralkylgruppe mit 7 bis 9 Kohlenstoffatomen, eine Aralkenylgruppe mit 8 oder9 Kohlenstoffatomen oder eine Gruppe der Formel-$(CH_2)_mR^7$ steht, wobei $R^7$ ein Halogenatom oder eine Gruppe der Formel $-OR^8$, $-SR^8$, $OAr^3$, $SAr^3$, $-OCOR^8$ oder $-COOR^8$ bedeutet und m 1, 2 oder 3 ist, $R^6$ für eine Gruppe der Formel $-CH_2CH(R^9)-$ oder $-CH_2CH(R^9)CH_2-$, $R^8$ für eine Alkylgruppe mit 1 bis 4 Kohlenstoffatomen und $R^9$ für ein Wasserstoffatom oder eine Alkylgruppe mit 1 bis 18 Kohlenstoffatomen stehen sowie $Ar^1$, $Ar^2$ und $Ar^3$ unabhängig voneinander je eine gegebenenfalls durch bis zu 3 unter Halogenatomen, Alkyl- oder Alkoxygruppen mit 1 bis 4 Kohlenstoffatomen und Phenylgruppen ausgewählte Substituenten substituierte Phenylgruppe darstellen.

Beispiele für Verbindungen der Formel VIII sind Benzildimethylketal, Benzildiäthylacetal, Benzil-di-(2-methoxyäthyl)-ketal und Benzil-di-(2-chloräthyl)-ketal. Verbindungen der Formel IX sind beispielsweise 2-Phenyl-2-benzoyl-4-methyl-1,3-dioxolan und 2-Phenyl-2-benzoyl-1,3-dioxan. Benzildimethylketal wird als Photosensibilisator besonders bevorzugt.

Verbindungen der Formel VIII bzw. IX sind in der GB-A-1 390 006 beschrieben, wo sie zur Photopolymerisation und Photovernetzung äthylenisch ungesättigter Verbindungen, wie Methylacrylat, styrolhaltigen Polyestern auf Maleinsäuregrundlage und Diallylphthalat-präpolymeren, eingesetzt werden.

Weitere als Photobeschleuniger geeignete Substanzen umfassen aromatisch-aliphatische Ketone einer der

Formeln

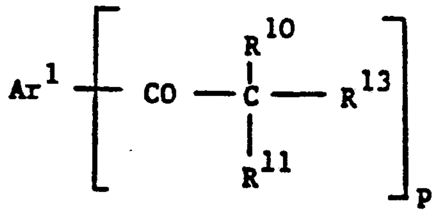

X

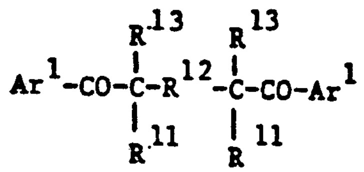

XI

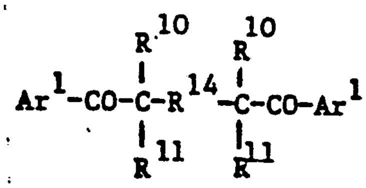

XII

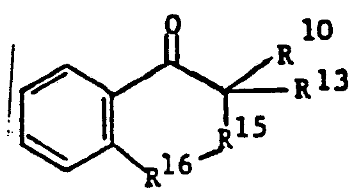

XIII,

worin $Ar^1$ die oben angegebene Bedeutung hat, $R^{10}$ und $R^{11}$ je eine einwertige aliphatische, cycloaliphatische oder araliphatische Gruppe oder zusammen mit dem daran gebundenen Kohlenstoffatom eine Cycloalkylengruppe $R^{12}$ eine Kohlenstoff-Kohlenstoffbindung oder einen zweiwertigen organischen Rest, $R^{13}$ eine Hydroxyl- oder Aminogruppe oder eine einwertige, verätherte oder silylierte solche Gruppe, $R^{14}$ eine zweiwertige Amino-, Aether- oder Siloxygruppe, $R^{15}$ eine direkte chemische Bildung oder $-CH_2-$ und $R^{16}$ -O-, -S-, $-SO_2-$, $-CH_2-$oder $-C(CH_3)_2-$ bedeuten.

Diese Verbindungen, zu deren bevorzugten Mitgliedern 2-Allyloxy-2-methylpropiophenon, 2-Benzyloxy-2-methylpropio-phenon, 2-Hydroxy-2-methyl-p-phenoxypropiophenon, 1-Benzoylcyclohexanol, 1-Benzoylcyclopentanol und Bis-(4-(α-hydroxy-isoburyl)-phenyl)-äther gehören, sind in der europäischen Patentanmeldung Nr. 0 003 002 ebenfalls als Photopolymerisationskatalysatoren für äthylenisch ungesättigte Verbindungen und als Photovernetzer für Polyolefine beschrieben.

Weitere zur Erhöhung der Photopolymerisationsgeschwindigkeit von 1,2-Epoxiden durch Salze der Formel I verwendbare Verbindungen sind 2-substituierte Thioxanthone der Formel

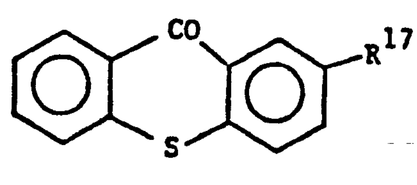

XIV,

worin $R^{17}$ entweder ein Chloratom oder eine Alkylgruppe mit 1 bis 6 Kohlenstoffatomen, wie eine Isopropyl- oder tert.-Butylgruppe, darstellt. Verbindungen der Formel XIV, insbesondere die 2-Chlorverbindung, werden industriell als Photopolymerisationskatalysatoren für äthylenisch ungesättigte Verbindungen und als

Photovernetzer für Polyolefine eingesetzt.

Es ist daher unerwartet, dass Verbindungen der Formeln VIII bis XIV die photoinduzierte Polymerisation von 1,2-Epoxiden mittels organometallischer Salze beschleunigen.

Vorzugsweise werden 0,5 bis 7,5 Gew.-% und insbesondere 1 bis 5 Gew.-% Photobeschleuniger, berechnet auf das Gewicht von (a), eingearbeitet.

In der Photopolymerisationsstufe wird vorzugsweise aktinische Strahlung einer Wellenlänge von 200 bis 600 nm verwendet. Zu geeigneten Quellen aktinischer Strahlung gehören Kohlelichtbögen, Quecksilberdampflichtbögen, Fluoreszenzlampen mit ultraviolettes Licht aussendenden Leuchtstoffen, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die zur Belichtung erforderliche leit hängt voh verschiedenen Faktoren ab, unter anderem beispielsweise der jeweils verwendeten polymerisierbaren Substanz, der Art der Lichtquelle und deren Abstand vom bestrahlten Material. Der mit der Photopolymerisationstechnik vertraute Fachmann kann leicht geeignete Zeiten bestimmen. Wenn es wie in einem unten beschriebenen Verfahren erforderlich ist, das Produkt so zu photopolymerisieren, dass es beim Erhitzen mit einem damit vermischten Heisshärter noch härtbar ist, dann muss die Bestrahlung natürlich bei einer Temperatur durchgeführt werden, die unter derjenigen liegt, bei der wesentliches Heisshärten des photopolymerisierten Produkts mittels des Heisshärters eintreten würde.

Die erfindungsgemässen Zusammensetzungen sind als Oberflächenbeschichtungen verwendbar. Dabei kann man sie auf Substrate wie, Stahl, Aluminium, Kupfer, Cadmium Zink, Papier oder Holz, aufbringen, vorzugsweise als Flüssigkeit, und bestrahlen. Bei teilweiser Polymerisation der Beschichtung, wie mittels Bestrahlung durch eine Maske hindurch lassen sich die unbelichteten Stellen mit einem Lösungsmittel zur Entfernung der unpolymerisierten Anteile auswaschen, während die photopolymerisierten, unlöslichen Anteile an Ort und Stelle verbleiben. So lassen sich die erfindungsgemässen Zusammensetzungen zur Herstellung von Druckplatten und gedruckten Schaltungen verwenden. Methoden zur Herstellung von Druckplatten und gedruckten Schaltungen aus photopolymerisierbaren Zusammensetzungen sind wohlbekannt (siehe z.B. GB-A-1 495 746).

Die Zusammensetzungen sind auch als Klebstoffe verwendbar. Eine Schicht der Zusammensetzung kann zwischen zwei Oberflächen von Gegenständen verstrichen werden, von denen mindestens eine für aktinische Strahlung durchlässig ist, z.B. aus Glas, und der Aufbau wird dann bestrahlt und gewünschtenfalls zur Vollendung der Polymerisation erhitzt.

Die Zusammensetzungen sind ferner nützlich zur Herstellung faserverstärkter Verbundstoffe, einschliesslich flächenförmiger Premix-Pressmassen.

Man kann sie direkt in flüssiger Form auf die Verstärkungsfasern (einschliesslich Spinnfäden, Filamenten und Whiskers), die als gewebtes oder ungewebtes Tuch, gerichtete Fasern oder geschnittene Spinnfäden vorliegen können, aufbringen.

Den faserverstärkten Verbundstoff kann man nach einem diskontinuierlichen Verfahren herstellen, wobei das faserige Verstärkungsmaterial auf einen zweckmässig unter schwacher Spannung gehaltenen Film der photopolymerisierten Zusammensetzung gelegt wird, wobei man gewünschtenfalls einen zweiten solchen Film darüberlegen kann, und der Aufbau wird unter Erhitzen verpresst. Man kann ihn auch kontinuierich herstellen, wie durch Inberührungbringen des faserigen Verstärkungsmaterials mit einem Film der photopolymerisierten lusammensetzung, dann gewünschtenfalls einen zweiten solchen Film auf die Rückseite des faserigen Verstärkungsmaterials legen und Hitze und Druck zur Einwirkung bringen. Zweckmässiger trägt man zwei solche, vorzugsweise auf der Rückseite durch Bänder oder abziehbare Folien abgestützte Filme gleichzeitig so auf das faserige Verstärkungsmaterial auf, dass jede freiliegende Fläche damit in Berührung kommt. Bei Verwendung zweier solcher Filme können diese gleich oder verschieden sein.

Mehrlagige Verbundstoffe lassen sich durch Erhitzen von Filmzwischenlagen und Schichten aus einem oder mehreren faserigen Verstärkungsmaterialien unter Druck herstellen. Bei gerichteten Fasern als Verstärkungsmaterial können aufeinanderliegende Schichten von diesen in kreuzweiser Anordnung ausgerichtet sein.

Mit dem faserigen Verstärkungsmaterial kann man auch weitere Verstärkungstypen wie Metall-, Kunststoff- oder Gummifolien, verwenden.

Bei der Herstellung von flächenförmigen Premix-Pressmassen wird eine erfindungsgemässe lusammensetzung mit dem Verstärkungsmaterial aus geschnittenen Spinnfäden und jeglichen weiteren Komponenten schichtweise durch Trägerfolien hindurch mit der Strahlung belichtet.

Die polymerisierbare Zusammensetzung wird vorzugsweise so aufgebracht, dass der Verbundstoff insgesamt 20 bis 80 Gew.-% dieser Zusammensetzung und entsprechend 80 bis 20 Gew.-% Verstärkung enthält. Besonders bevorzugt werden insgesamt 30 bis 50 Gew.-% der Zusammensetzung eingesetzt.

Die erfindungsgemässen Zusammensetzungen sind zur Herstellung von Kitten und Spachtelmassen verwendbar. Sie können als Tauchüberzüge eingesetzt werden, wobei ein zu beschichtender Gegenstand in die flüssige Zusammensetzung eingetaucht und herausgezogen und der anhaftende Ueberzug zur Photopolymerisation und somit Verfestigung bestrahlt und gewünschtenfalls danach erhitzt wird.

Es wurde gefunden, dass es möglich ist, unter Verwendung der erfindungsgemässen Zusammensetzungen Epoxidharze in zwei Stufen zu härten; das Harz wird zunächst durch Belichtung mit aktinischer Strahlung in Gegenwart eines organometallischen Salzes der Formel I und eines latenten, hitzeaktivierbaren

Vernetzungsmittels für das Epoxidharz in die teilweise gehärtete B-Stufe überführt, und in einer zweiten Stufe wird die teilweise gehärtete Zusammensetzung so erhitzt, dass sie durch das hitzeaktivierbare Vernetzungsmittel ausgehärtet wird. Somit kann man eine flüssige oder halbflüssige Zusammensetzung herstellen, die dann geformt oder zum Tränken eines Substrats verwendet werden kann, während sie zur Verfestigung bestrahlt wird; gewünschtenfalls wird der verfestigte Körper dann erhitzt, um das Harz auszuhärten.

Ein anderer Gegenstand dieser Erfindung ist dementsprechend ein Verfahren zur Polymerisation eines Epoxidharzes, dadurch gekennzeichnet, dass man a) ein Epoxidharz in Gegenwart einer zur Polymerisation des Epoxidharzes wirksamen Menge eines organometallischen Salzes der Formel I und einer härtenden Menge eines latenten Heisshärters für das Epoxidharz zur Bildung eines B-Stufenprodukts bestrahlt und gegebenenfalls b) die Zusammensetzung durch Erhitzen aushärtet.

Ein weiterer Gegenstand ist eine Zusammensetzung, die ein Epoxidharz, eine zu dessen Polymerisation bei Belichtung der Zusammensetzung mit aktinischer Strahlung wirksame Menge eines organometallischen Salzes der Formel I und eine härtende Menge eines latenten Heisshärters für das Epoxidharz enthält.

Zu geeigneten hitzeaktivierbaren Vernetzungsmitteln für die Epoxidharzzusammensetzungen zählen Polycarbonsäureanhydride, Komplexe von Aminen, insbesondere primären oder tertiären aliphatischen Aminen, wie Aethylamin, Trimethylamin und n-Octyldimethylamin, mit Bortrifluorid oder Bortrichlorid und latente Bordifluoridchelate. Aromatische Polyamine und Imidazole werden üblicherweise nicht vorgezogen, da man dabei eher unbefriedigende Ergebnisse erzielt, möglicherweise wegen einer Reaktion zwischen dem freigesetzten sauren Katalysator und dem Amin. Dicyandiamid lässt sich erfolgreich einsetzen, vorausgesetzt dass es als verhältnismässig grobe Teilchen vorliegt.

Die zur Heisshärtung erforderliche Temperatur und Erhitzungsdauer sowie die Anteile an hitzeaktivierbarem Härter lassen sich leicht durch Serienversuche feststellen und sind ohne weiteres aus den wohlbekannten Tatsachen über die Heisshärtung von Epoxidharzen herleitbar.

Dank der in den Zusammensetzungen enthaltenen Gruppen, über die sie nach der Photopolymerisation heissgehärtet werden können, sind sie besonders nützlich bei der Herstellung mehrschichtiger gedruckter Schaltungen.

Ueblicherweise wird eine mehrschichtige gedruckte Schaltung aus mehreren, zweiseitig bedruckten Leiterplatten aus Kupfer hergestellt, die übereinander gestapelt und voneinander durch Isolierfolien, meist aus mit einem Epoxidharz in der B-Stufe imprägnierten Glasfasern, getrennt sind. Wenn der Schicht des photopolymerisierbaren Epoxidharzes in der Leiterplatte kein Heisshärter beigemischt ist, so kann dieser in die mit den Platten alternierenden Isolierschichten eingearbeitet werden, wobei diese Schichten zweckmässig aus einem Epoxidharzpräpreg bestehen; vorausgesetzt, dass dieser nicht zu dick ist, wandert eine genügende Menge des in dem Präpreg enthaltenen Heisshärters aus, um Vernetzung des photopolymerisierten Epoxidharzes einzuleiten. Der Stapel wird erhitzt und zwecks Verbund der Schichten verpresst. Herkömmliche photopolymerisierbare Materialien bilden jedoch weder mit Kupfer noch mit harzimprägnierten Glasfaserbögen starke Verbindungen. Ein mit dem Photopolymer verbundener, das Kupfer noch bedeckender Stapel ist deshalb an sich schwach, und im Gebrauch kann Schichtentrennung auftreten. Es ist deshalb übliche Praxis, das verbleibende Photopolymer nach der Aetzstufe entweder mittels starker Lösungsmittel oder durch eine mechanische Methode, z.B. mittels Bürsten, zu entfernen. Ein solches Abstreifverfahren kann das Kupfer der gedruckten Schaltung oder die Oberfläche des Schichtkörpers, auf dem die Schaltung liegt, beschädigen, so dass ein Bedarf für eine Methode besteht, bei welcher die Notwendigkeit, das photopolymerisierte Material vor der gegenseitigen Verbindung der Platten zu entfernen, entfallen würde. Die Gegenwart der restlichen 1,2-Epoxidgruppen bedeutet, dass beim Verbinden der Platten Vernetzung eintreten kann, was zu guter Haftung am Kupfer und am harzimprägnierten Glasfasersubstrat führt und damit die eben erwähnte Notwendigkeit ausschaltet.

Bei einer weiteren Anwendung mit Heisshärtung nach der Photopolymerisation der erfindungsgemässen Zusammensetzungen handelt es sich um das Fadenwickelverfahren. Dabei wird ein Endloskabel der Faserverstärkung mit einer einen latenten Heisshärter für Epoxidharze enthaltenden lusammensetzung getränkt und dann unter Belichtung des Wickels mit aktinischer Strahlung um einen Dorn gewickelt. Solche Fadenwickel besitzen noch ein gewisses Ausmass an Biegsamkeit, so dass der Dorn leichter entfernbar ist, als wenn ein starrer Wickel in einer Stufe gebildet würde. Erforderlichenfalls erhitzt man den Wickel zur Vernetzung der Zusammensetzung.

Bei einer weiteren solchen Anwendung wird eine Schicht der Zusammensetzung in flüssiger Form bestrahlt, bis sie sich verfestigt, was einen Filmkleber ergibt, der dann zwischen zwei zu verbindende Oberflächen in Berührung damit eingelegt wird, und der Aufbau wird erhitzt, um die Vernetzung der Zusammensetzung zu Ende zu führen. Der Film kann auf einer Seite mit einer abziehbaren Trennfolie versehen sein. Der Aufbau ist häufig leichter zu handhaben, wenn der Film eine klebrige Oberfläche besitzt. Diese lässt sich dadurch erzielen, dass man den Film mit einer bei Raumtemperatur klebrigen Substanz überzieht, die aber unter den zur Vollendung der Vernetzung der Zusammensetzung angewandten Hitzebedingungen zu einem harten unlöslichen, unschmelzbaren Harz vernetzt. Ein genügendes Ausmass an Klebrigkeit besteht jedoch häufig ohne zusätzliche Behandlung, insbesondere wenn die Polymerisation der Zusammensetzung nicht zu weit fortgeschritten ist. Als Verklebungssubstrate eignen sich unter anderem Metalle, wie Eisen, Zink, Cadmium, Kupfer, Nikkel und Aluminium, Keramik, Glas und Gummiarten.

Die nachfolgenden Beispiele dienen der Erläuterung der Erfindung. Falls nicht anders angegeben, sind Teile

Gewichtsteile.

Epoxidharz I bedeutet einen Diglycidyläther des 2,2-Bis-(4-hydroxyphenyl)-propans mit einem Epoxidgehalt von 5,2 val/kg.

Epoxidharz II bedeutet den 3,4-Epoxicyclohexylmethyl-ester der 3,4-Epoxicyclohexancarbonsäure.

Epoxidharz III bedeutet ein vorverlängertes Epoxidharz mit einem Epoxidgehalt von 2,30 val/kg, das durch Umsetzung von Bisphenol-A-diglycidyläther (38,56 Teile) mit Bisphenol A (10,82 Teile) in herkömmlicher Weise hergestellt wurde.

Epoxidharz IV bedeutet einen Diglycidyläther des 1,4-Butandiols mit einem Epoxidgehalt von 9,35 val/kg.

Epoxidharz V bedeutet einen epoxidierten Bisphenol-A-novolak mit einem Erweichungspunkt von 72°C und einem Epoxidgehalt von 4,9 val/kg.

Die in diesen Beispielen eingesetzten Organoeisensalze werden nach A.J. Birch u.a., a.a.O., hergestellt.

<u>π=1-Methyl-5,6,7,8-tetrahydronaphthalin-tricarbonylmangan-hexafluorophosphat</u>

Dieses wird nach der Methode von T.H. Coffield, V. Sandel und R.D. Closson, a.a.O., hergestellt.

Man rührt ein Gemisch aus Pentacarbonylmanganbromid (2,5 g), Aluminiumchlorid (2 g) und 1-Methylnaphthalin 6 Stunden unter Stickstoff bei 100°C. Man kühlt ab und hydrolysiert mit 100 g Eiswasser und versetzt die abgetrennte wässrige Lösung mit in 30 ml Wasser gelöstem Kaliumhexafluorophosphat (1,7 g). Der gelbe Niederschlag wird abfiltriert, mit Eiswasser gewaschen und 16 Stunden bei 40°C/13 000 N/m getrocknet. Das Produkt besitzt einen Schmelzpunkt von 175°C (Zers.).

(Gefunden: C, 39,55; H, 3,25; F, 26,6; Mn, 12,6; P, 7,2,
Berechnet für $C_{14}H_{14}F_6MnO_3P$-C, 39,09; H, 3,28; F, 26,50; Mn, 12,77; P, 7,20%).

<u>π-Toluol-tricarbonylmangan-hexafluorophosphat</u>

Dieses wird auf ähnliche Weise nach der Methode von T.H. Coffield u.a. (a.a.O.) hergestellt. Das Produkt schmilzt über 250°C.

(Gefunden: C, 31,9; H, 2,2; F, 31,7; Mn, 14,8.
Berechnet für $C_{10}H_8F_6MnO_3P$: C, 31,94; H, 2,14; F, 30,31; Mn, 14,61; 0, 12,76; P, 8,24%).

<u>π-Methoxybenzol-tricarbonylmangan-hexafluorophosphat</u>

Unter Stickstoff erhitzt man ein Gemisch aus Pentacarbonylmanganbromid (2,5 g), Aluminiumchlorid (2 g) und Methoxybenzol (30 ml) 3,5 Stunden unter Rühren auf 110°C. Man kühlt ab und hydrolysiert mit 100 g Eiswasser und versetzt die abgetrennte wässrige Lösung mit in 30 ml Wasser gelöstem Kaliumhexafluorophosphat (1,7 g). Der gelbe Niederschlag wird abfiltriert, mit Eiswasser gewaschen und 16 Stunden bei 40°C/13 000 N/m$^2$ getrocknet. Das Produkt schmilzt über 290°C.

(Gefunden: C, 30,5; H, 2,2; F, 29,6; Mn, 13,4.
Berechnet für $C_{10}H_8F_6MnO_4P$: C, 30,64; H, 2,06; F, 29,07; Mn, 14,01).

<u>π-Hexyloxybenzol-tricarbonylmangan-hexafluorophosphat</u>

Dieses wird auf ähnliche Weise wie die entsprechende Methoxybenzolverbindung hergestellt, unter Ersatz des Methoxybenzols durch Hexyloxybenzol (30 ml). Das Produkt schmilzt bei 146-151°C.

<u>π-Hexylbenzol-tricarbonylmangan-hexafluorophosphat</u>

Dieses wird auf ähnliche Weise wie die entsprechende Methoxybenzolverbindung hergestellt, wobei man Hexylbenzol (10 ml) zusammen mit Octan (20 ml) anstelle des Methoxybenzols verwendet. Das Produkt schmilzt bei 148-151°C.

(Gefunden: C, 39,9; H, 4,1; F, 25,8; Mn, 12,0.
Berechnet für $C_{15}H_{18}F_6MnO_3P$: C, 40,38; H, 4,07; F, 25,55; Mn, 12,31).

## BEISPIELE 1-6

Man vermischt Epoxidharz I und Tricarbonyl-(cyclohexadienylium)-eisensalze wie in der nachfolgenden Tabelle angeführt, zieht die Zusammensetzungen als 6 µm dicke Filme auf Weissblech auf und setzt diese dann im Abstand von 20 cm der Strahlung einer Mitteldruckquecksilberlichtbogenlampe (80 W pro cm) für die angegebene Zeit aus. Die erhaltenen Ergebnisse sind ebenfalls in Tabelle I angeführt.

**TABELLE 1**

| Beispiel Nr. | Komplex Name | Komplex Gewichtsmenge auf Harz | Bestrahlungszeit | Ergebnis |
|---|---|---|---|---|
| 1 | Tricarbonyl-(cyclohexa-1,3-dienylium)-eisen-tetrafluoroborat | 2 % | 2 Minuten | etwas klebriger Film, der beim Stehen klebfrei wird |
| 2 | Tricarbonyl-(1-methylcyclohexa-2,4-dienylium)-eisen-hexafluorophosphat | 3 % | 2 Minuten | klebfreier Film |
| 3 | Tricarbonyl-(1-methyl-4-methoxycyclohexa-2,4-dienylium)-eisen-hexafluorophosphat | 2 % | 2 Minuten | klebfreier Film |
| 4 | Tricarbonyl-(2-methoxybicyclo [4.4.0]-deca-2,4-dienylium)-eisen-hexafluorophosphat | 3 % | 40 Sekunden | klebfreier Film |
| 5 | Tricarbonyl-(1-(acetoxymethyl)-2-(methoxycarbonylacetoxy)-äthyl-cyclohexa-2,4-dienylium-eisen-hexafluorophosphat | 4 % | 2 Minuten | etwas klebriger Film, der beim Stehen klebfrei wird |
| 6 | Tricarbonyl-(1-methoxycarbonyl)-4-methoxycyclohexa-2,4-dienylium)-eisen-tetra-fluoroborat | 3 % | 2 Minuten | etwas klebriger Film, der beim Stehen klebfrei wird |
| — | ohne | — | 20 Minuten | keine Wirkung |

**BEISPIELE 7-8**

Man verfährt wie in Beispielen 1 bis 6 mit Epoxidharz II. Die erhaltenen Ergebnisse sind in Tabelle II angeführt.

**TABELLE II**

| Beispiel Nr. | Komplex Name | Gewichtsmenge auf Harz | Bestrahlungszeit | Ergebnis |
|---|---|---|---|---|
| 7 | Tricarbonyl-(1-methylcyclohexa-2,4-dienylium)-eisen-hexafluoro-phosphat | 3 % | 2 Minuten | etwas klebriger Film, der beim Stehen klebfrei wird |
| 8 | Tricarbonyl-(2-methoxybicyclo [4.4.0]-deca-2,4-dienylium)-eisen-hexafluoro-phosphat | 3 % | 5 Sekunden | klebfreier Film |

**BEISPIEL 9**

Man bringt ein Gemisch aus 5 g Epoxidharz II, 0,2 g π-1-Methyl-5,6,7,8-tetrahydronaphthalin-tricarbonyleisen-hexafluorophosphat und 1 Tropfen handelsüblichem Verlaufmittel (einem Fluorkohlenstoff) wie in Beispielen 1 bis 6 auf Weissblech auf. Nach 12 Sekunden Bestrahlung wird der Film klebfrei. Nach 10 Minuten Erhitzen auf 100°C widersteht der Film 12-13-maligem Reiben bei der Norm-Acetonreibprüfung auf Lösungsmittelbeständigkeit, bei der ein in Aceton getränkter Wattebausch über die Oberfläche gerieben wird.

**BEISPIEL 10**

Man löst Epoxidharz III (49,38 Teile) in einem Gemisch aus Aceton (14,81 Teile) und Aethylmethylketon (34,57 Teile). Dazu gibt man π-Toluol-tricarbonylmangan-hexafluorophosphat (1,5 Teile) und streicht die homogene Lösung auf eine kupferkaschierte Platte aus Epoxidharz/Glaslaminat mittels einer 24 µm-Auftragswalze (d.h. der nasse Film ist 24 µm dick). Nach 20 Minuten Trocknen bei 75°C wird der Ueberzug 3 Minuten durch einen Stouffer-21-Stufenkeil hindurch mit einer 5 000 W Metallhalogenidlampe bestrahlt. Die Platte wird 3 Minuten bei 80°C erhitzt und dann mit Aethylmethylketon entwickelt. Aetzen in 50%iger Ferrichloridlösung liefert ein Stufenbild Nr. 2.

**BEISPIELE 11-13**

Diese in Tabelle III angeführten Beispiele erläutern die Verwendung von Photoinitiatoren zusammen mit einem Komplex der Formel I zur Photopolymerisation eines Epoxidharzes. Dabei verfährt man wie in Beispielen 1 bis 6. In Beispiel 11 wird Epoxidharz II sowie in Beispielen 12 und 13 Epoxidharz I verwendet.

Tabelle III

| Beispiel Nr | Komplex Name | Komplex Gewichtsmenge auf Epoxidharz | Photoinitiator Name | Photoinitiator Gewichtsmenge auf Epoxidharz | Bestrahlungszeit zur Bildung eines klebfreien Films |
|---|---|---|---|---|---|
| 11 | Tricarbonyl-(2-methoxy-bicyclo [4.4.0] deca-2,4-dienylium)-eisen-hexafluorophosphat | 3 % | — | — | 5 Sekunden |
| | Tricarbonyl-2-methoxy-bicyclo [4.4.0] deca-2,4-dienylium)-eisen-hexafluorophosphat | 3 % | Benzildimethylketal | 3 % | 1—2 Sekunden |
| 12 | Tricarbonyl-(1-methyl-4-methoxycyclohexa-2,4-dienylium)-eisen-hexa-fluorophosphat | 3 % | — | — | 3 Minuten |
| | Tricarbonyl-(1-methyl-4-methoxycyclohexa-2,4-dienylium)-eisen-hexafluorophosphat | 3 % | Benzildimethylketal | 3 % | 1 Minute |
| 13 | Tricarbonyl-(1-äthyl-4-isopropoxycyclohexa-2,4-dienylium)-eisen-hexafluorophosphat | 4 % | — | — | 40 Sekunden |
| | Tricarbonyl-(1-äthyl-4-isopropoxycyclohexa-2,4-dienylium)-eisen-hexafluorophosphat | 4 % | 2-Chlorthioxanthon | 4 % | 25 Sekunden |

In Beispielen 14 bis 23 wird ein Epoxidharz photopolymerisiert und anschliessend heissgehärtet.

## BEISPIEL 14

Man bringt ein Gemisch aus 5 Teilen Epoxidharz I, 0,2 Teilen Tricarbonyl-(1-äthyl-4-isopropoxycyclohexa-2,4-dienylium)-eisen-hexafluorophosphat und 0,2 Teilen Bortrichlorid/Trimethylaminkomplex als 6μm dicken Ueberzug auf Weissblech auf und bestrahlt im Abstand von 20 cm 50 Sekunden mit einer Lampe (80 W pro cm). Der Film ist klebfrei. Beim Reiben mit einem in Aceton getränkten Wattebausch wird der Ueberzug nach zweimaligem Reiben angegriffen. Danach erhitzt man die Platte 1 Stunde auf 150°C, wonach der Ueberzug erheblich grössere Lösungsmittelbeständigkeit aufweist und 13-maligem solchem Reiben widersteht.

## BEISPIEL 15

Man bringt ein Gemisch aus Epoxidharz I (100 Teile), π-Methoxybenzol-tricarbonylmangan-hexafluorophosphat (3 Teile) und Aceton (3 Teile) als 8 μm dicken Ueberzug auf Weissblech auf. Der Ueberzug wird unter Verwendung einer Mitteldruckquecksilberlichtbogenlampe (80 W pro cm) im Abstand von 20 cm bestrahlt und dann im Ofen auf 120°C erhitzt. 30 Sekunden Bestrahlung mit nachfolgendem 10 Minuten langem Erhitzen liefert einen harten, klebfreien Film.

**BEISPIEL 16**

Man verfährt wie in Beispiel 15, unter Ersatz des Hexafluorophosphats durch π-Hexyloxybenzol-tricarbonylmangan-hexafluorophosphat (3 Teile). 30 Sekunden Bestrahlung des Ueberzugs mit nachfolgendem 3 Minuten langem Erhitzen liefert einen klebfreien Film.

**BEISPIEL 17**

Man verfährt wie in Beispiel 15, unter Ersatz des Hexafluorophosphats durch π-Hexylbenzoltricarbonylmanganhexafluorophosphat (3 Teile). 20 Sekunden Bestrahlung des Ueberzugs mit nachfolgendem, 1 Minute langem Erhitzen ergibt einen klebfreien Film.

**BEISPIEL 18**

Man verfährt wie in Beispiel 15, unter Verwendung eines Gemischs aus Epoxidharz I (50 Teile), Epoxidharz II (30 Teile), Epoxidharz IV (20 Teile), π-Hexylbenzol-tricarbonylmangan-hexafluorophosphat (3 Teile) und Aceton (3 Teile) anstelle des in Beispiel 15 eingesetzten Gemischs. 10 Sekunden Bestrahlung des Ueberzugs mit nachfolgendem, 1 Minute langem Erhitzen ergibt einen harten klebfreien Film.

**BEISPIEL 19**

Man verfährt wie in Beispiel 18, unter Ersatz des Hexafluorophosphats durch das gleiche Gewicht π-Hexyloxybenzol-tricarbonylmangan-hexafluorophosphat. 10 Sekunden Bestrahlung mit nachfolgendem, 2 Minuten langem Erhitzen liefert einen harten, klebfreien Film.

**BEISPIEL 20**

Man verfährt wie in Beispiel 18, unter Ersatz des Hexafluorophosphats durch das gleiche Gewicht π-Methoxybenzol-tricarbonylmangan-hexafluorophosphat. 10 Sekunden Bestrahlung mit nachfolgendem, 2 Minuten langem Erhitzen liefert einen klebfreien Film.

**BEISPIEL 21**

Man bringt ein Gemisch aus Epoxidharz V (60 Teile), Epoxidharz II (40 Teile), π-Methoxybenzol-tricarbonylmanganhexafluorophosphat (3 Teile) und Aceton (5 Teile) als 8 µm dicken Ueberzug auf Weissblech auf. Der Ueberzug wird unter Verwendung einer Mitteldruckquecksilberlampe (80 W pro cm) im Abstand von 20 cm bestrahlt und dann im Ofen auf 100°C erhitzt. 20 Sekunden Bestrahlung mit nachfolgendem, 3 Minuten langem Erhitzen ergibt einen klebfreien Film.

**BEISPIEL 22**

Man verfährt wie in Beispiel 21, unter Ersatz des Hexafluorophosphats durch das gleiche Gewicht π-Hexyloxybenzol-tricarbonylmangan-hexafluorophosphat. 20 Sekunden Bestrahlung mit nachfolgendem, 35 Sekunden langem Erhitzen ergibt einen klebfreien Film.

**BEISPIEL 23**

Man verfährt wie in Beispiel 21, unter Ersatz des Hexafluorophosphats durch das gleiche Gewicht π-Hexylbenzoltricarbonylmangan-hexafluorophosphat. 20 Sekunden Bestrahlung mit nachfolgendem, 1 Minutelangem Erhitzen harten, klebfreien Film.

**Patentansprüche**

1. Polymerisierbare Zusammensetzungen enthaltend
(a) eine mindestens eine 1,2-Epoxidgruppe enthaltende Verbindung bzw. ein Gemisch solcher Verbindungen und
(b) eine wirksame Menge eines Salzes der Formel
$[Y\text{-}Q\text{-}(CO)_a]^+ MX_n^-$ I.
worin Y eine Arengruppe oder cyclische Dienyliumgruppe bedeutet, Q ein Atom eines unter Titan, Vanadium, Chrom, Mangan, Eisen, Kobalt, Nickel, Kupfer, Niob, Molybdän, Ruthenium, Rhodium, Palladium, Silber; Tantal, Wolfram, Rhenium, Osmium, Iridium, Platin und Gold ausgewählten d-Block-übergangsmetalls darstellt, a eine solche positive ganze lahl ist, dass das Atom Q eine geschlossene Elektronenschalenkonfiguration aufweist, M ein Atom eines Metalls oder Nichtmetalls darstellt, n 4, 5 oder 6 und um eins grösser als die Wertigkeit von M ist und X für ein Fluor- oder Chloratom steht, mit der Massgabe, dass, wenn M Antimon darstellt, n 6 ist und fünf der Symbole X für Fluor stehen, eines auch eine Hydroxogruppe bedeuten kann.

2. Zusammensetzungen nach Anspruch 1, worin Y eine gegebenenfalls durch eine oder mehrere Alkoxygruppen substituierte Arenkohlenwasserstoffgruppe bedeutet.

3. Zusammensetzungen nach Anspruch 1, worin Y eine cyclische Dienyliumgruppe einer der folgenden Formeln

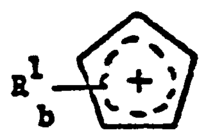
II

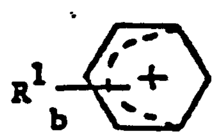
III

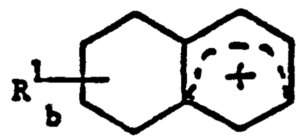
IV

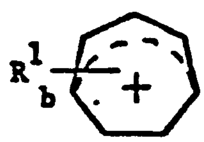
V

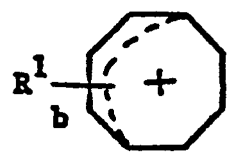
VI,

worin $R^1$ für eine Alkylgruppe mit 1 bis 4 Kohlenstoffatomen, eine Alkoxygruppe mit 1 bis 4 Kohlenstoffatomen oder eine durch eine oder mehrere Oxycarbonylgruppen unterbrochene Alkylgruppe mit bis zu 12 Kohlenstoffatomen steht und b null, 1, 2 oder 3 ist, bedeutet.

4. Zusammensetzungen nach Anspruch 1, worin Q Chrom, Kobalt, Nickel, Eisen oder Mangan darstellt.

5. Zusammensetzungen nach Anspruch 1, worin M Antimon, Arsen, Bor oder Phosphor darstellt.

6. Zusammensetzungen nach Anspruch 1, worin (a) ein Epoxidharz mit mehr als einer endständigen, direkt an ein Sauerstoffatom gebundenen Gruppe der Formel

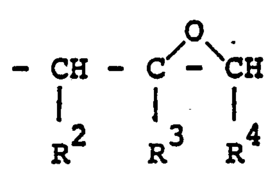
VII,

worin entweder $R^2$ und $R^4$ je für ein Wasserstoffatom stehen, wobei $R^3$ dann ein Wasserstoffatom oder eine Methylgruppe bedeutet oder $R^2$ und $R^4$ zusammen $-CH_2CH_2-$ darstellen, wobei $R^3$ dann ein Wasserstoffatom bedeutet, ist.

7. Zusammensetzungen nach Anspruch 6, worin Y in der Formel I eine Arengruppe bedeutet und als (a) ein Epoxidharz mit direkt an cycloaliphatische Kohlenstoffatome qebundenen 1,2-Epoxidgruppe vorliegt.

8. Zusammensetzungen nach Anspruch 6 oder 7, enthaltend ferner einen latenten Heisshärter für das Epoxidharz.

9. Zusammensetzungen nach Anspruch 1, enthaltend 0,5 bis 7,5 Gewichtsteile (b) auf 100 Gewichtsteile (a).

10. Zusammensetzungen nach Anspruch 1, enthaltend ferner einen Photobeschleuniger.

11. Zusammensetzungen nach Anspruch 1, enthaltend den Diglycidyläther des 2,2-Bis-(4-hydroxyphenyl)-propans (Epoxidgehalt 5,2val/kg) und Tricarbonyl-(2-methoxybicyclo-[4.4.0]deca-2,4-dienylium)-eisen-hexafluorophosphat.

12. Verfahren zur Ueberführung einer mindestens eine 1,2-Epoxidharzgruppe enthaltenden Verbindung bzw. eines Gemisches solcher Verbindungen in hühermolekulares Material, dadurch gekennzeichnet, dass man eine Zusammensetzung gemäss Anspruch 1 aktinischer Strahlung aussetzt.

13. Verfahren gemäss Anspruch 12, dadurch gekennzeichnet, dass man

a) ein Epoxidharz in Gegenwart einer zur Polymerisation des Epoxidharzes wirksamen Menge einer Verbindung der Formel I und einer härtenden Menge eines latenten Heisshärters für das Epoxidharz zur Bildung eines teilweise gehärteten B-Stufenproduktes bestrahlt, und gegebenenfalls

b) die Zusammensetzung durch Erhitzen aushärtet.

14. Verwendung der Zusammensetzungen gemäss Anspruch 1, als Oberflächenbeschichtungen, in Druckplatten, in gedruckten Schaltungen, in verstärkten Verbundstoffen und als Klebstoffe.

**Claims**

1. A polymerisable composition comprising

(a) a compound, or mixture of compounds, containing at least one 1,2-epoxide group,

(b) an effective amount of a salt of the formula

$$\left[ Y - Q - (CO)_a \right]^{+} \quad MX_n^{-} \qquad \text{I}$$

where

Y represents an arene group or a cyclic dienylium group,

Q represents an atom of a d-block transition element chosen from titanium, vanadium, chromium, manganese, iron, cobalt, nickel, copper; niobium, molybdenum, ruthenium, rhodium, palladium, silver; tantalum, tungsten, rhenium, osmium, iridium, platinum, and gold,

a is a positive integer such that the atom Q has a closed electron shell configuration,

M represents an atom of a metal or metalloid,

n is 4, 5, or 6, and is one more than the valency of M, and

X represents a fluorine or chlorine stom, with the proviso that if M represents antimony, n is 6, and five of the symbols X represent fluorine, then one may alternatively represent a hydroxo group.

2. A composition according to claim 1, wherein Y represents an arene hydrocarbon group which is unsubstituted or substituted by one or more alkoxy groups.

3. A composition according to claim 1, wherein Y represents a cyclic dienylium group chosen from groups of the following formulae

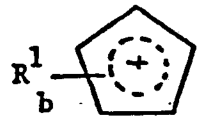

II

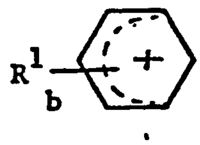

III

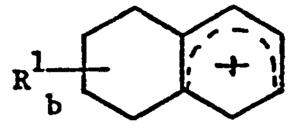

IV

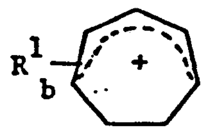

V

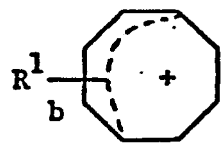

VI

where

$R^1$ denotes an alkyl group of 1 to 4 carbon atoms, an alkoxy group of 1 to 4 carbon atoms, or an alkyl group interrrupted by one or more oxycarbonyl groups and containing up to 12 carbon atoms, and

b is zero, 1, 2; or 3.

4. A composition according to claim 1, wherein Q represents chromium, cobalt, nickel, iron, or manganese.

5. A composition according to claim 1, wherein M represents antimony, arsenic, boron, or phosphorus.

6. A composition according to claim 1, wherein (a) is an epoxide resin containing more than one group of formula

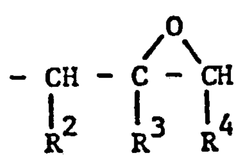

VII

directly attached to an atom of oxygen, where either $R^2$ and $R^4$ each represent a hydrogen atom, in which case $R^3$ denotes a hydrogen atom or a methyl group, or $R^2$ and $R^4$ together represent $-CH_2CH_2-$, in which case $R_3$ denotes a hydrogen atom.

7. A composition according to claim 1, wherein Y in formula 1 denotes an arene group and (a) is an epoxide resin having 1,2-epoxide groups directly linked to cycloaliphatic carbon atoms.

8. A composition according to either of claims 6 or 7, which also contains a latent heat-curing agent for the epoxide resin.

9. A composition according to claim 1, containing from 0.5 to 7.5 parts by weight of (b) per 100 parts by weight of (a).

10 A composition according to claim 1, which also contains a photoaccelerator.

11. A composition according to claim 1, which contains the diglycidyl ether of 2,2-bis(4-hydroxyphenyl)propane (epoxide content 5.2 val/kg) and tricarbonyl-(2-methoxybicyc1o[4.4.0]deca-2,4-dienylium)iron hexafluorophosphate.

12. A Process for converting a compound containing at least one 1,2-epoxide resin group, or a mixture of such compounds, into high molecular material, which comprises exposing a composition as claimed in claim 1 to actinic radiation.

13. A process according to claim 12, which comprises

a) irradiating an epoxide resin in the presence of a compound of formula I in an amount sufficient to polymeric the epoxide resin, and of a latent heat curing agent for the epoxide resin in an amount sufficient to form a partially cured β-stage product, and, if desired,

b) curing the composition by heating.

14. Use of a composition as claimed in claim 1 as surface coating, in printing plates, in printed circuits, in reinforced composites, and as adhesive.

**Revendications**

1. Compositions polymérisables contenant a) un composé contenant au moins un groupe époxyde-1,2 ou un mélange de tels composés et b) une quantité efficace d'un sel de formule

$$\left[Y - Q - (CO)_a\right]^+ \qquad MX_n^- \qquad I$$

dans laquelle Y représente un groupe arène ou un groupe diénylium cyclique, Q représente un atome d'un métal de transition d choisi parmi le titane, le vanadium, le chrome, le manganèse, le fer, le cobalt, le nickel, le cuivre; le niobium, le molybdène, le ruthénium, le rhodium, le palladium, l'argent; le tantale, le tungstène, le rhénium, l'osmium, l'iridium, le platine et l'or, a est un nombre entier positif tel que l'atome Q présente une configuration de la couche électronique complète, M représente un atome de métal ou de métalloïde, n est 4, 5 ou 6 et est supérieur de 1 à la valence de M et X est un atome de fluor ou de chlore, sous réserve que, lorsque M représente de l'antimoine, n est 6, cinq des symboles X sont du fluor et l'un peut également représenter un groupe hydroxo.

2. Compositions selon la revendication 1, dans lesquelles Y représente un groupe hydrocarboné arène, éventuellement substitué par un ou plusieurs groupes alcoxy.

3. Compositions selon la revendication 1, dans lesquelles Y représente un groupe diénylium cyclique répondant à l'une des formules suivantes:

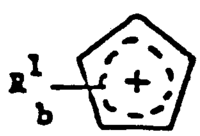

II

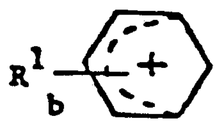

III

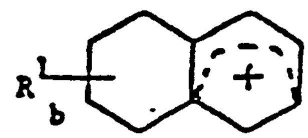

IV

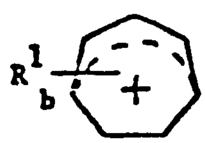

V

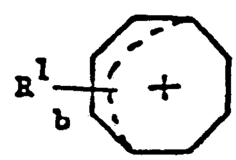

VI

ou $R^1$ représente un groupe alkyle avec 1 à 4 atomes de carbone, un groupe alcoxy avec 1 à 4 atomes de carbone ou un groupe alkyle possédant jusqu'à 12 atomes de carbone interrompu par un ou plusieurs groupes oxycarbonyles et b est 0, 1, 2 ou 3.

4. Compositions selon la revendication 1, dans lesquelles Q représente le chrome, le cobalt, le nickel, le fer ou le manganèse.

5. Compositions selon la revendication 1, dans lesquelles M est l'antimoine, l'arsenic, le bore ou le phosphore.

6. Compositions selon la revendication 1, dans lesquelles (a) est une rèsine époxyde comportant plus d'un groupe terminal directement lié à un atome d'oxygène, de formule

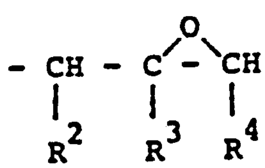

VII

dans laquelle $R^2$ et $R^4$ sont chacun un atome d'hydrogène, auquel cas $R^3$ représente alors un atome d'hydrogène ou un groupe méthyle, ou $R^2$ et $R^4$ représentent ensemble $-CH_2CH_2-$, auquel cas $R^3$ représente alors un atome d'hydroène.

7. Compositions selon la revendication 6, dans lesquelles Y dans la formule I représente un groupe arène et est présent sous forme (a) d'une résine époxyde comportant un groupe époxy-1,2 directement lié à des atomes de carbone cycloaliphatiques.

8. Compositions selon la revendication 6 ou 7, renfermant en outre un durcisseur thermique latent pour la résine époxyde.

9. Compositions selon la revendication 1, contenant 0,5 à 7,5 parties en poids de (b) pour 100 parties en poids de (a).

10. Compositions selon la revendication 1, contenant en outre un photo-accélérateur.

11. Compositions selon la revendication 1, contenant l'éther diglycidique du bis-(hydroxy-4 phényl)-2,2 propane (teneur en époxy 5,2 val/kg) et de l'hexafluorophosphate de tri-carbonyl-(méthoxy-2 bicyclo[4,4,0]décadiène-2,4 ylium)fer.

12. Procédé de conversion d'un composé renfermant au moins un groupe époxy-1,2 ou d'un mélange de tel composés en un matière de poids moléculaire supérieur, caractérisé en ce qu'on expose une composition selon la revendication 1 à un rayonnement actinique.

13. Procédé selon la revendication 12, caractérisé en ce que

a) on irradie une résine époxyde en présence d'une quantité d'un composé de formule I efficace pour la polymérisation de la résine époxyde et d'une quantité durcissante d'un durcisseur thermique latent pour la résine époxyde en vue de la formation d'un produit partiellement durci correspondant au stade B et

b) on durcit éventuellement la composition par chauffage.

14. Utilisation des compositions selon la revendication 1 comme revêtement de surface, dans des plaques d'impression, des circuits imprimés, des composites renforcés et comme adhésifs.